# EUROPEAN PATENT APPLICATION

(11) **EP 4 524 424 A1**
(43) Date of publication of application: **19.03.2025**
(21) Application number: 23386134.3
(22) Date of filing: 13.12.2023
(51) Int. Cl.: F16F 15/00

(54) **METHOD OF INCREMENTAL AMPLIFICATION MORPHO-TRANSDUCER DESIGN IN BRANCHED PIEZOELECTRICS**

(30) Priority: 18.09.2023 GR 20230100752
(71) Applicant: TECHNICAL UNIVERSITY OF CRETE, 73100 Chania, Crete (GR)
(72) Inventor: Marakakis, Konstantinos, GR-73200 Souda, Chania (GR); Daraki, Maria-Styliani, GR-73131 Chania, Crete (GR); Stavroulakis, Georgios, GR-73132 Chania, Crete (GR)
(74) Representative: Panagiotidou, Effimia

(57) **Abstract**

The invention proposes the use of an incremental layer and in particular a passive mechanical morpho-transducer (D), which may be composed of one or more materials and formed by a microstructure designed by the proposed design method, which realizes through its deformability, the passive transducer, to increase the efficiency of branched piezoelectric systems. In this method, the proposed morpho-transducer (D), i.e., the incremental layer between the parent structure (A) and the piezoelectric (B), transforms the deformable state without the noise caused by the Poisson effect, and through this enhancement, increases the efficiency of the system.

## Description

The invention belongs to the field of engineering of intelligent and complex electromechanical structures, and in particular to the field of branched piezoelectric pads. In particular, it proposes the use of a morpho-transducer to enhance the cooperation between the parent structure and the piezoelectric pad, and ultimately increase the efficiency of the system. In addition, it proposes a method of designing the morpho-transducer using topological optimization techniques of flexible mechanism.

The branched piezoelectric pads convert the mechanical energy transferred to them from the adjacent mechanical structure into electrical energy and consume it within a suitably configured electrical or electronic circuit. In this way, a reduction in the oscillations of the overall structure is achieved, resulting in, among other things, reduced damage due to fatigue of the structure's components, increased service life, and greater precision of movements in flexible machine components. Energy transfer is achieved through the joint deformation of the adjacent layers of the parent oscillating structure and the piezoelectric pad. Since the strain transferred through this interface is reduced due to shrinkage of the adjacent structure through the swelling ratio (Poisson's ratio), a way to increase the degree of cooperation between the structure and the piezoelectric pad is sought to enhance the energy transfer efficiency. In particular, the classical method of welding the piezoelectric directly to the parent structure cannot address the above technical problem solved by the present invention, because it is due to incompatibility (different mode) of operation of the two adjacent deformable elements that cannot be cured by any of the proposed solutions of the current technique.

As far as the branched piezoelectric systems are concerned, the solutions proposed so far are the careful welding or integration of the piezoelectric systems into the oscillating structure, the selection of the appropriate location for their placement in order to absorb as much energy as possible, and the optimal design of their other components, mainly their electrical and electronic circuits, in order to operate in the desired way in the operating areas of interest. These steps are general design principles and do not affect the problem of reduced cooperation solved by the present invention, which enhances the efficiency of the whole structure.

The use of engineered metamaterials and in particular growth materials to enhance cooperation between adjacent elements has been inspired by similar applications in energy harvesting systems. This is the closest technical application to the proposed invention.

Related prior art for incremental reinforcement in energy harvesting sensors and devices is proposed in the following documents.

In the US document 20220373415 "Piezoelectric sensor having a membrane made of auxetic metamaterial for enhanced sensitivity", the use of an incremental substrate is proposed to enhance the sensitivity of a sensor based on the piezoelectric effect. Alternative practical ways of implementing the growth substrate are proposed, The difference is that, in the present invention the growth layer is integrated into an overall intelligent electromechanical system that achieves oscillation reduction.

Document 20210399203 "Metamaterial based substrate for piezoelectric energy harvesters" similarly proposes the use of an incremental substrate to enhance the efficiency of an energy harvesting system based on the piezoelectric effect. The difference with the present invention is that this paper does not disclose application at specific frequencies and does not mention oscillation reduction.

Document 308206 "Auxetic structure with electromechanical conversion" similarly proposes the use of an incremental substrate to enhance the efficiency of an electromechanical conversion system. The difference with the present invention relates to the detailed design of the morpho-transducer and its adjustment as required, with the ultimate goal of reducing oscillations.

In the paper 108470825 "Magneto-electric surface acoustic wave device based on negative Poisson's ratio magnetostriction substrate" the use of an incremental substrate is proposed to modify the acoustic wave propagation behavior. The difference lies in the use of piezoelectric materials in combination with electrical circuitry as proposed in the present invention.

### Related publications

Daraki, M.-S.; Marakakis, K.; Stavroulakis, G.E. Modeling of Shunted Piezoelectrics and Enhancement of Vibration Suppression through an Auxetic Interface.Micromachines 2023, 14, 289.
Koutsianitis, P.I., Tairidis, G.K. & Stavroulakis, G.E. Shunted piezoelectric pads on auxetic microstructures for the enhancement of band gaps.Arch Appl Mech 91, 739-751 (2021). https://doi.org/10.1007/s00419-020-01804-1
Z. Hadas, V. Slaby, J. Bajer, A. Filková, F. Ksica and P. Marcian, "Design Concept and Test Results of Electromechanical Metamaterial Structure for Sensing and Energy Harvesting Applications," 2022 20th International Conference on Mechatronics - Mechatronika (ME), Pilsen, Czech Republic, 2022, pp. 1-6, doi: 10.1109/ME54704.2022.9983153.
Dong, S.; Hu, H. Sensors Based on Auxetic Materials and Structures: A Review.Materials 2023, 16, 3603.
Tabak, A., Safaei, B., Memarzadeh, A. et al. An Extensive Review of Piezoelectric Energy-Harvesting Structures Utilizing Auxetic Materials.J. Vib. Eng. Technol. (2023).
Zhou, X., Parida, K., Chen, J., Xiong, J., Zhou, Z., Jiang, F., Xin, Y., Magdassi, S., Lee, P. S., 3D Printed Auxetic Structure-Assisted Piezoelectric Energy Harvesting and Sensing.Adv. Energy Mater. 2023, 2301159.
Eghbali, P., Younesian, D., Moayedizadeh, A. et al. Study in circular auxetic structures for efficiency enhancement in piezoelectric vibration energy harvesting.Sci Rep 10, 16338 (2020).
Nikolaos T. Kaminakis, Georgios E. Stavroulakis, Topology optimization for compliant mechanisms, using evolutionary-hybrid algorithms and application to the design of auxetic materials, Composites Part B: Engineering, Volume 43, Issue 6, 2012, Pages 2655-2668, ISSN 1359-8368,

The present invention enables the application of branched piezoelectric elements to reduce oscillations using industrially produced, standard piezoelectric elements which have specific properties. The classical method of soldering directly the piezoelectrics to the parent structure, which is the proposed solution by the current technique, cannot address the technical problem solved by the present invention, because it is due to an incompatibility of operation of the two adjacent deformable elements that is not cured by any solution of the current technique.

The present invention proposes the use of an incremental layer and in particular a passive mechanical morpho-transducer, which may be composed of one or more materials (including but not limited to metal, plastic, and in general materials that can be used with 3D printing techniques) and can be formed (illustratively) by a printed microstructure that implements, through its deformability, the proposed passive transducer, to increase the efficiency of branched piezoelectric systems. The proposed enhancement of the cooperation between the mother structure and piezoelectric element is based on engineering principles, does not consume energy and has not been used so far. With the present technique, the proposed transducer, i.e., the incremental layer between the parent structure and the piezoelectric element, converts the deformation state without the noise caused by the Poisson effect, and through this enhancement, increases the efficiency of the system. The present invention exploits deformability properties of the suitably designed morpho-transducer and proposes its application to an intelligent structure that has not been used to date.

The present invention also proposes a method of designing the morpho-transducer which is based on topological optimization principles for distributing the material or materials within the morpho-transducer and creating a microstructure to achieve deformability as required by the needs of the application. The proposed mechanical morpho-transducer transforms the deformational state in the transverse direction of the oscillating beam and changes its sign (from tension to compression and vice versa). A first simple approach is based on an incremental microstructure using for example a star-shaped incremental microstructure which is repeated throughout the body of the transducer. A more accurate design is possible by distributing the material within the deformable morpho-transducer by means of topological optimization techniques of flexible mechanism, which aim at the aforementioned desired deformation state.

Without the proposed invention, because the deformation of the parent structure is not transferred as such to the piezoelectric pad due to the Poisson's ratio swelling effect, a part of the energy that the piezoelectric should collect is lost and consequently the efficiency of the system is reduced. The invention allows the use of standard piezoelectric elements to build intelligent structures with integrated branched piezoelectric elements, and optimize electromechanical cooperation by using a passive incremental morpho-transducer which does not consume energy. The addition of the proposed morpho-transducer cures the aforementioned problem.

The use of standard piezoelectrics is sought after in industry and drastically reduces the cost of developing new applications. The use of passive, power-free morpho-transducers leads to technically simpler solutions, because no power supply and associated wiring is required, and ultimately to more economical products. The specific way of designing and manufacturing the growth layer has not been disclosed.

The deformable state in the transverse direction of the oscillating beam and the change of its sign (from tension to compression and vice versa) achieved by the proposed mechanical morpho-transducer, has the advantage that the connection to the piezoelectric sensor works more efficiently. Also, an essential advantage of the invention is that it operates passively, without energy consumption, through the mechanical deformation of the morpho-transducer and the appropriately designed microstructure.

The drawings accompanying the Description briefly illustrate:
Figure 1 schematically illustrates the deformation on the top side of a curved beam made of classical material (Fig. 1a) and of incremental material (Fig. 1b), according to the current state of the art.
Figure 2 illustrates the overall electromechanical system with the beam, piezoelectric, electronic circuit and shows the location where the proposed morpho-transducer will be inserted.
Figure 3 illustrates the response of the electromechanical system at various operating frequencies. It depicts the oscillation curves without the damping and with the influence of the branched circuit to reduce the oscillation, according to the current state of the art.
Figure 4 illustrates the generation of incremental material via a star-shaped microstructure, according to the current state of the art.
Figure 5 depicts an incremental continuum by the repeated use of the star-shaped microstructure, according to the prior art level.
Figure 6 illustrates a possible embodiment of the morpho-transducer of the present invention using the star-shaped microstructures of Figure 5.
Figure 7 illustrates the morpho-transducer in perspective view of the system shown in front view in Figure 2: Figure 7a illustrates a possible embodiment of the morpho-transducer of the present invention using microstructures derived from the topological optimization analysis of a flexible mechanism.
Figure 7b illustrates above and below the morpho-transducer with thin lines the piezoelectric pad and beam.
Figure 8 shows the steps of the method of topological optimization for flexible mechanisms implemented by the present invention and the material distribution image on the morpho-transducer until the final microstructure is found.

The invention is identified by the Claims.

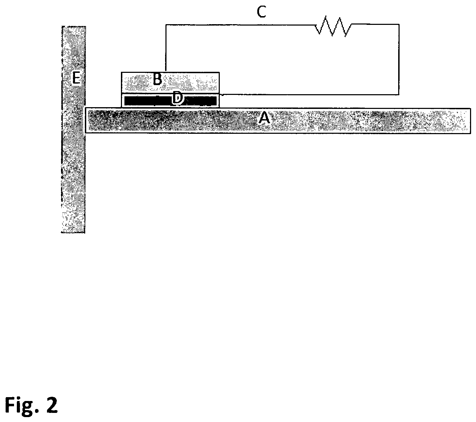

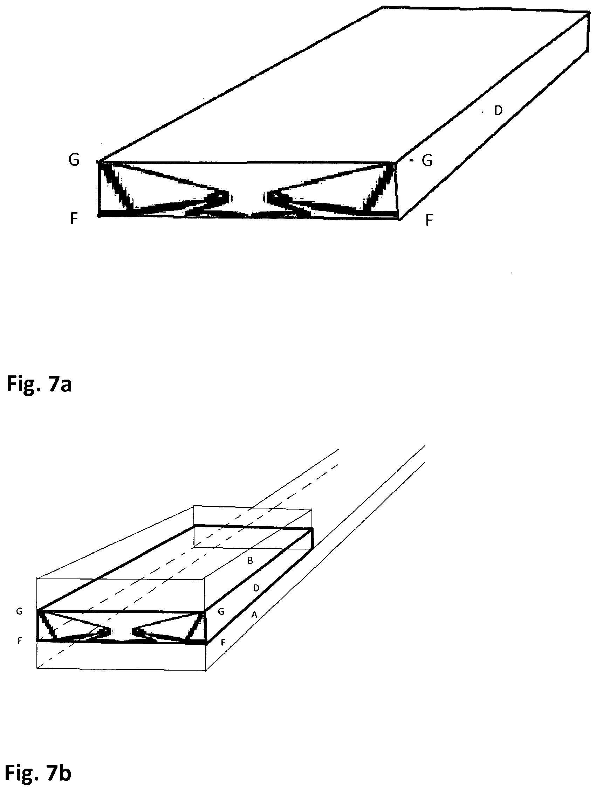

The main form of microstructure according to the present inventive method is to design it using topological optimization techniques for designing flexible mechanisms. As illustrated in Figs. 2 and 7, the possible implementation of an incremental morpho-transducer (D) using topological optimization leads to the design of the optimal microstructure to have the desired deformation behavior, i.e., tensile in the F-F direction is converted to compression in the G-G direction and vice versa, as illustrated in Figs. 7a and 7b.

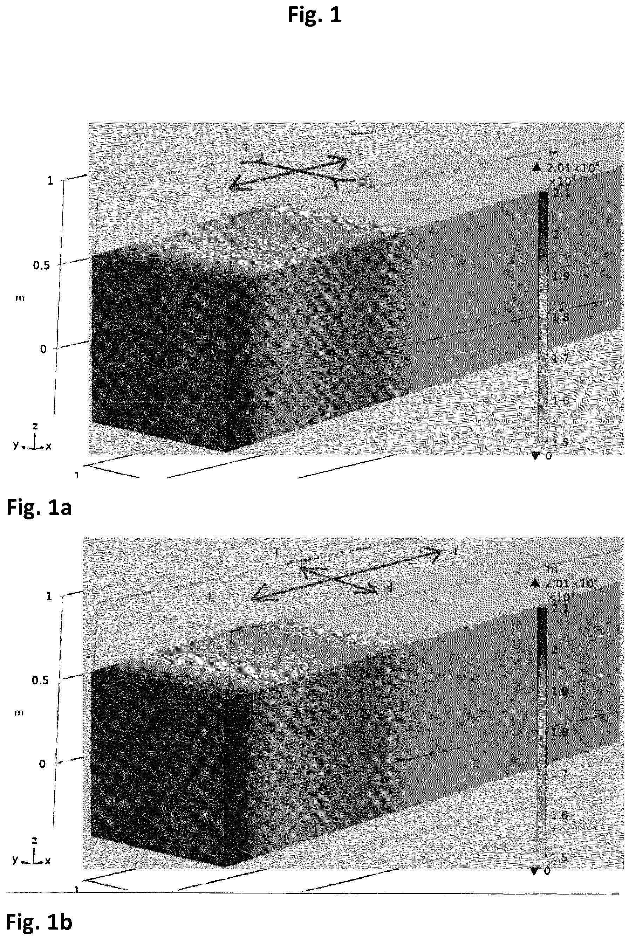

Specifically, as illustrated in Figures 1a and 1b, to cure the deformation incompatibility between the parent structure and the piezoelectric sensor, a morpho-transducer is designed which will take as input the transverse strain and change the shape of the strain, i.e. if bending of, for example, a beam causes elongation in the main direction, along the beam, direction L-L in drawing 1a, the Poisson's ratio of the parent structure leads to a shrinkage in the transverse sense, direction T-T.

The morpho-transducer of the present invention picks up this shrinkage and converts it, through its deformation, into elongation, with the result that the piezoelectric pad receives uniform deformation in both directions, i.e. in this case elongation in both the main and transverse directions. The design of the microstructure to meet the requirements of the proposed morpho-transducer is carried out according to the steps of the topological optimization method for deformable mechanisms, which are described below.

For each application, i.e. for each different dimension and material of the oscillating beam (including other types of structures such as plates, shells, etc.), and for each different dimension and properties of the piezoelectric pad, the appropriate morpho-transducer is designed according to the method of the present invention.

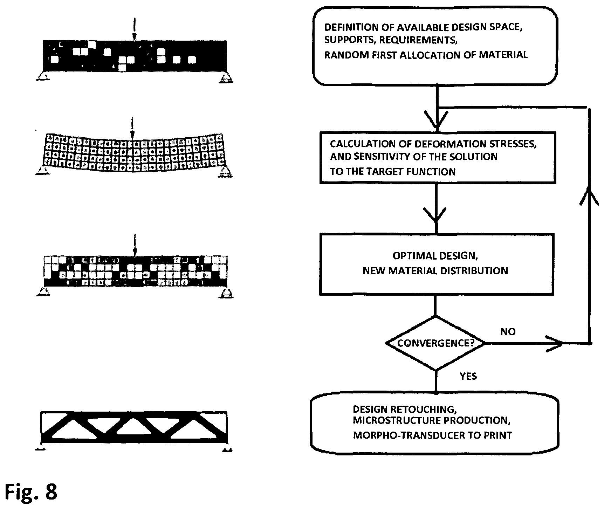

The method of designing the microstructure of the mechanical morpho-transducer through topological optimization of a flexible mechanism is schematically described in Fig. 8. At the beginning, the maximum available design space, supports and loadings and the requirements to be met by the transducer, i.e. the deformation mode as mentioned above in Fig. 7 are defined and quantified using known optimal design techniques. In addition a first random material distribution is made. The deformable beam is then solved for the given material distribution, the developing stresses and strains are calculated, the rate of change of the function that quantifies the requirements to change each design variable, i.e. the sensitivity of the solution to the objective function, is calculated, and the optimal design step proceeds by calculating a new modified material distribution. The iterative process continues until convergence, i.e. until it is not possible to calculate a better material distribution that differs substantially from the existing one within the specified numerical accuracy limit, in accordance with the principles of optimization. The final material distribution is retouched, taking into account any additional requirements due to technology and manufacturing accuracy that cannot be quantified in the previous steps, and the final design of the microstructure of the morpho-transducer is ready for printing or other suitable manufacturing.

More specifically, the steps of the method of designing the microstructure of a morpho-transducer for the needs of the proposed invention are as follows (Fig. 8).
STEP A: The available space for the morpho-transducer (intermediate layer between the parent deformable structure and the piezoelectric pad) is delineated using a 3D finite element or other numerical technique.
STEP B: In each partition of the region, finite element in this case, a design parameter is used which indicates the existence or not of material, for example when it takes values 1 and 0 respectively.
STEP C: An optimal design problem is formulated with the aforementioned design parameters of step B as design parameters and the objective of the optimization problem being the desired deformation state. With reference to Fig. 7, the objective is to reverse the deformation of the morpho-transducer from the base F-F which is adjacent to the transverse deformation of the parent beam, to the vertex G-G, which connects the morpho-transducer to the piezoelectric pad. For example, the function to be optimized yields the degree of transfer, with a change of sign, of the aforementioned deformation.
STEP D: The optimal design problem is solved numerically using topological optimization techniques of flexible mechanism and as a result, the values of the design parameters and finally the requested microstructure of the morpho-transducer which realizes the desired deformation behavior are obtained. The numerical solution method has two parts. First, the objective function and any side conditions are formulated, for example the percentage of the volume that is required to be covered with material. Then the structure is solved, the stresses and strains within it are found, the points where material can be added or removed are selected by means of a sensitivity analysis which indicates the points where material modification (addition or removal) is required in order to approach the optimum, then the values of the design parameters are modified and the process is repeated until convergence.
STEP E: The resulting microstructure is then further refined by smoothing corners and other stress concentration points to minimize waste during the printing process. The microstructure is ready for printing.

Subsequently, it is described in detail how the present inventive method is implemented.

The principle of operation of an incremental morpho-transducer according to the prior art is shown in the following figure of an elastic, deformable beam in bending (Fig. 1). As illustrated in Fig. 1, in the first case of a beam made of a classical material with a positive swell ratio, the main stress on the upper side (Fig. 1a direction L-L) in tension (elongation) is complemented by compression (acceleration) in the transverse direction (Fig. 1a direction T-T), which acceleration acts parasitically and reduces the cooperation with any piezoelectric overlay. In the second case (growth material with a negative swelling ratio, Fig. 1b) the upper side is stressed uniformly in tension in both L-L and T-T directions, and consequently the cooperation with a possible piezoelectric insert is improved, due to the stress of the same shape as shown by the growth material. Therefore, in a beam made of growth material (Fig. 1b), the possible piezoelectric pad on the upper side of the beam will receive the same form of stress in both directions, thus improving the ability to transfer energy from mechanical deformation to electrical signal.

The placement of a branched piezoelectric allows the transfer of kinetic energy from a vibrating beam to electrical energy through the piezoelectric pads, which in turn is transferred to an electrical circuit and lost in the form of heat. The schematic arrangement of an oscillating beam/structure (A) (Fig. 2), which has a piezoelectric pad (B) mounted on it electrically connected to a branched circuit (C) is an example of an embodiment of the proposed inventive concept. The proposed incremental reinforcement layer, i.e. the morpho-transducer (D) is placed between the piezoelectric pad (B) and the oscillating structure (A).

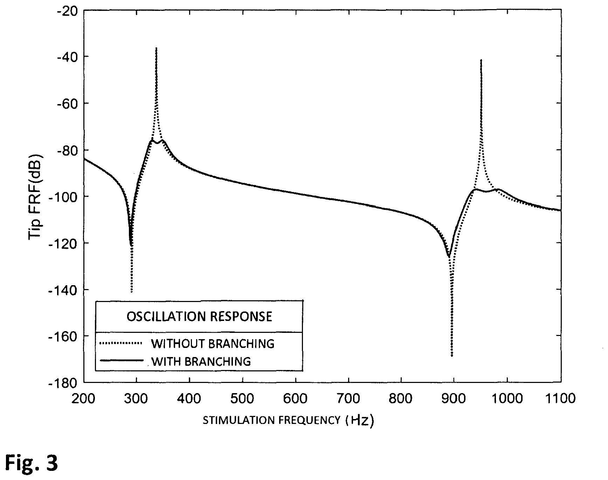

The circuit can be suitably designed to cut off the oscillation at selected frequencies, such as the natural frequencies of the structure, thus avoiding resonances, excessive oscillations, material fatigue and other undesirable phenomena. An illustrative diagram showing the response of the beam (A) at various excitation frequencies and the damping function by means of a branched circuit is shown in Fig. 3: the oscillating structure under the influence of a periodic external force responds differently at each position and at each excitation frequency. Around the oscillation eigenvalues of the structure the resonance effect occurs and the oscillation shows peaks with maximum oscillation amplitude. The effect of the shunt circuit, and the transfer of energy from kinetic to electrical through the piezoelectric pad, leads to a reduction of this oscillation. The proposed improvement through the morpho-transducer further enhances this effect.

The morpho-transducer insertion enhances the electromechanical coupling and ultimately the damping effect due to branched piezoelectric.

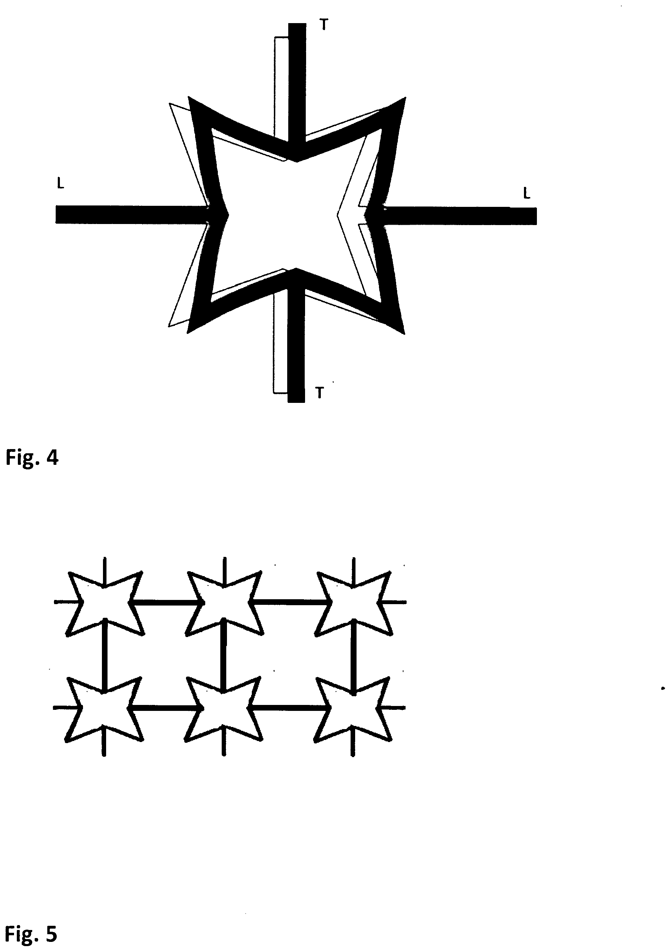

The creation of the growth effect for the morpho-transducer may be based on the existence of a star-shaped microstructure or other suitable microstructure. As illustrated in Fig. 4, according to the current technique, the basic star-shaped microstructure for generating the growth medium if subjected to tensile stress in the L-L direction swells in the transverse T-T direction. One possible embodiment of the growth morpho-transducer may be the repeated use of the star-shaped microstructure of Fig. 4, as illustrated in Fig. 5. It may be fabricated by subtractive or additive manufacturing techniques or any other suitable techniques.

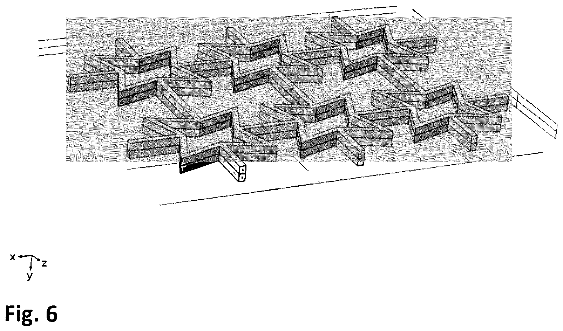

Alternatively, a further possibility of the system is to use a morpho-transducer based on known microstructures of the current technique which result in incremental behavior, such as the star-shaped microstructure illustrated in Figs. 3, 4, 5, 6.

**[0028]** The invention may find application in high precision engineering equipment manufacturing companies such as aerospace companies (including sub-manufacturers) and high precision and high speed robotics manufacturing. Also, to machine and acoustic device system subcontractors as well as manufacturers and metrology system specialists.

## Claims

1. An oscillation damping pad for a structure (A) comprising a morphotropic incremental pad (D) carrying a piezoelectric pad (B) electrically connected to a shunt circuit (C) **characterized in that** the morphotropic incremental pad/morpho-transducer (D) is placed between the oscillating structure (A) and the piezoelectric pad (B).

2. An oscillation damping pad for a structure (A) according to claim 1, **characterized in that** the morphotropic incremental pad/morpho-transducer (D) is designed using topological optimization of a flexible mechanism that realizes desired deformation behavior and reverses the deformation from the F-F base of the morpho-transducer (D), which is adjacent to the transverse deformation of the oscillating structure, to the top G-G of the transducer (D), which connects the morpho-transducer (D) to the piezoelectric patch.

3. An oscillation damping pad for a structure (A) according to claim 1, **characterized in that** the microstructure of the morphotropic growth patch/morpho-transducer (D) is star-shaped.

4. Use of a morpho-transducer (D) incrementally amplifying an oscillating structure (A) of the damping pad of claims 1-3, **characterized in that** the morpho- transducer (D) is positioned between the piezoelectric pad (B), which is electrically connected by a branched circuit (C), and the oscillating structure (A).

5. Use of a morpho-transducer (D) for incremental amplification of an oscillating structure (A) according to claim 4, **characterized in that** the morpho-transducer (D) is placed on the structure and connects it to the piezoelectric patch (B), receives as input the transverse strain and changes the shape of the strain, to such a point that the piezoelectric patch receives a similar form of strain in its two directions, both in the principal and in the transverse direction.

6. Use of a morpho-transducer (D) according to any one of claims 1-5, **characterized in that** a star-shaped microstructure transducer of the present technique or other incremental microstructure, fabricated by subtractive or additive manufacturing techniques or any other suitable techniques, is used and is placed between the piezoelectric patch (B), which is electrically connected by a shunt circuit (C), and the vibrating structure (A).
